# EUROPÄISCHE PATENTSCHRIFT

(11) **EP 3 323 277 B1**
(45) Veröffentlichungstag und Bekanntmachung des Hinweises auf die Patenterteilung: **05.06.2019**
(21) Anmeldenummer: 16739440.2
(22) Anmeldetag: 11.07.2016
(51) Int. Cl.: H05K 3/22, H05K 13/04, B60T 17/00, B60T 13/66, B60T 13/68, H05K 3/34

(54) **VERFAHREN ZUR AUFBEREITUNG EINES MECHATRONISCHEN SYSTEMS FÜR EIN NUTZFAHRZEUG SOWIE MECHATRONISCHES SYSTEM**
METHOD FOR PREPARING A MECHATRONIC SYSTEM FOR A UTILITY VEHICLE AND A MECHATRONIC SYSTEM
PROCÉDÉ DE PRÉPARATION D'UN SYSTÈME MÉCATRONIQUE POUR UN VÉHICULE UTILITAIRE AINSI QUE SYSTÈME MÉCATRONIQUE

(30) Priorität: 15.07.2015 DE 102015111432
(43) Veröffentlichungstag der Anmeldung: 23.05.2018
(73) Patentinhaber: KNORR-BREMSE Systeme für Schienenfahrzeuge GmbH, 80809 München (DE)
(72) Erfinder: KÖHLER, Daniel, 85757 Karlsfeld (DE); KROCKENBERGER, Klaus, 90547 Stein (DE); LECHNER, Klaus, 91362 Pretzfeld (DE); WATTS, Martin, Stoke Gifford Bristol BS34 8GG (GB)
(86) Internationale Anmeldenummer: PCT/EP2016/066382
(87) Internationale Veröffentlichungsnummer: WO 2017/009270

(56) Entgegenhaltungen:
- DE-A1- 3 428 812
- DE-A1- 4 328 603
- DE-A1-102013 006 860
- GB-A- 2 091 036
- US-A- 3 903 581

## Beschreibung

Die vorliegende Erfindung betrifft ein Verfahren zur Aufbereitung eines mechatronischen Systems für ein Nutzfahrzeug sowie ein mechatronisches System für ein Nutzfahrzeug.

Mechatronische System für Nutzfahrzeuge, insbesondere pneumatische Systeme für Nutzfahrzeuge, umfassen beispielsweise ein Parkbremssystem zur Festlegung des Fahrzeugs im Stand sowie eine Luftaufbereitungsanlage zur Reinigung von mit Feuchtigkeit, Öl und sonstigen Verunreinigungen belasteter Luft. In diesen Systemen werden elektrisch steuerbare Magnetventile eingesetzt, die über ihre Schaltzustände die angelegte Druckluft weiterleiten können oder aber die ihr nachgeschalteten Systeme von der angelegten Druckluftquelle trennen und/oder mit einer Entlüftung verbinden können. Die Magnetventile sind häufig als 2/2-Wegeventile ausgestaltet, die einen Drucklufteingang und einen Druckluftausgang aufweisen und zwischen einer Sperrstellung und einer Durchlassstellung geschaltet werden können. Es kann ferner vorgesehen sein, dass es sich bei den Magnetventilen um 3/2-Wegeventile handelt, wobei die Magnetventile in der von der Druckluftquelle getrennten Stellung die nachgeschalteten Systemkomponenten mit einer Entlüftungseinrichtung verbinden können. Auf diese Weise werden in der von der Druckluftquelle getrennten Stellung die nachfolgenden Systemkomponenten entlüftet, das heißt es liegt keine Druckluft, sondern nur Luft mit Umgebungsdruck an. Nachfolgende Komponenten der Druckluftsysteme sind beispielsweise pneumatische Ventile, deren Schaltstellungen über eine anliegende Druckluft gesteuert werden, oder Select-High-Ventile bzw. Select-Low-Ventile, die jeweils zwei anliegende Druckluftleitungen aufweisen, wobei die Druckluft weitergeleitet wird, deren Druck höher bzw. niedriger ist.

Die Luftaufbereitungsanlage, welche die der Luftaufbereitung zugeteilten Komponenten umfasst, ist ein zentrales Teilsystem des pneumatischen Systems, insbesondere von Nutzfahrzeugen, in der öl- und wasserhaltige Luft gefiltert und gereinigt wird. Die von einem Kompressor stammende komprimierte Luft wird unter Druck und in der richtigen Befüllreihenfolge den verschiedenen Bremskreisen und sonstigen Druckluftverbrauchern im Nutzfahrzeug zugeteilt. Im Defektfall werden die einzelnen Verbraucherkreise gegeneinander abgesichert.

In der Luftaufbereitungsanlage können für eine Regenerationsfunktion typischerweise zwei elektrisch steuerbare Ventile, insbesondere Magnetventile, genutzt werden, um eine definierte Menge trockener, unter Vorratsdruck stehender Luft durch eine Trockenmittelpatrone hindurch auf Umgebungsdruck zu expandieren, wobei so Feuchtigkeit und Verunreinigungen aus der Trockenmittelpatrone ausgetragen werden. Dabei kann durch die Magnetventile ein Ablassventil geöffnet werden, so dass die feuchte Luft aus der Luftaufbereitungsanlage an die Umgebung abgegeben werden kann. Es ist auch möglich, dass die Magnetventile ein Energiesparsystem des das pneumatische System mit Druckluft versorgenden Kompressors steuern. Wird das Energiesparsystem des Kompressors mit Druckluft beaufschlagt, so wird die Kompressorleistung stark reduziert.

Luftaufbereitungsanlagen sind beispielsweise aus der DE 20 2011 012 031 A1 bekannt, wobei ein erstes als Magnetventil ausgebildetes steuerbares Ventil und ein zweites ebenfalls als Magnetventil ausgebildetes steuerbares Ventil die Regeneration einer Trockenmittelpatrone steuern. Die Regeneration und Entlüftung der verschmutzten Luft erfolgen dabei über ein pneumatisch angesteuertes Ablassventil und eine Entlüftungsleitung.

In der GB 2 091 036 A ist darüber hinaus eine Trägeranordnung für eine integrierte Schaltung mit einer Trägereinheit gezeigt, in der ein Flatpack mit einem Kühlkörper montiert ist, und einer Schutzeinheit, in der die Trägereinheit montiert ist. Die Schutzeinheit umgibt die Trägereinheit und schützt die Leitungen des Flatpacks. Um das Flatpack auf eine Leiterplatte zu montieren, muss lediglich die Schutzeinheit entfernt und anschließend die Leitungen an den Leitern auf der Leiterplatte befestigt werden. Ferner kann ein fehlerhaftes Flatpack von einer Leiterplatte entfernt werden, indem die Leitungen auf der Innenseite der Trägereinheit abgetrennt und die (verkürzten) Leitungen eines Ersatz-Flatpacks mit den ursprünglichen Leitungen verlötet werden.

Zudem zeigt die DE 43 28 603 A1 eine Vorrichtung zum Entfernen eines elektronischen Bauelements von einer gedruckten Leiterplatte, wobei Anschlußstifte des elektronischen Bauelements jeweils in Durchgangslöcher der gedruckten Leiterplatte eingeführt und auf der gedruckten Leiterplatte durch Löten fest montiert sind, wobei die gedruckte Leiterplatte eine erste Hauptoberfläche, der gegenüber ein Körper des elektronischen Bauelements angeordnet ist, und eine zweite Hauptoberfläche hat, von der körperferne Endbereiche der Anschlußstifte überstehen.

Weiter offenbart die DE 34 288 12 A1 eine mehrschichtige gedruckte Schaltungsplatte mit abwechselnden Schichten aus Epoxy-Glas und stromleitendem Material, wobei eine Pqlyimid-Glas-Schicht auf einer Seite der Schaltungsplatte und stromleitende Anschlußflächen auf der Außenseite der Polyimid-Glas-Schicht zur Verbindung mit Bauelementestiften vorgesehen ist, um die Gefahr einer Beschädigung der Schaltungsplatte während des Entfernens und Auswechselns von mit der Schaltungsplatte befestigten Bauelementen zu verringern.

Die US 3,903,581 A zeigt weiter ein Verfahren zur Reparatur von Lötverbindungen, insbesondere von Lötverbindungen, die zur Verbindung von Mikrominiaturbauteilen mit Leiterplatten und Karten verwendet werden, die von einem Schutzbeschichtungsmaterial mit einer höheren Schmelztemperatur als die Schmelztemperatur des Lotes eingekapselt sind. Das Verfahren ermöglicht ein schnelles Entlöten der Bauteilanschlüsse und den Austausch der Bauteile ohne Beschädigung der Leiterplatte oder der Leiterplattenleitungen. So kann die Leiterplatte repariert und wiederverwendet werden, anstatt sie zu entsorgen und durch eine kostspielige neue zu ersetzen.

Die vorstehend beschriebenen Luftaufbereitungsanlagen für pneumatische Systeme, insbesondere pneumatische Systeme von Nutzfahrzeugen sind hinsichtlich ihrer Lebensdauer bzw. Standzeit durch die eingesetzten Magnetventile limitiert. Denn nach einer gewissen Standzeit sind die Magnetventile verschleißbedingt auszutauschen.

Um einen vollständigen Austausch der Luftaufbereitungsanlage zu vermeiden, wäre es wünschenswert, lediglich die Magnetventile der Luftaufbereitungsanlage auszutauschen.

Es ist daher die Aufgabe der vorliegenden Erfindung, ein Verfahren zur Aufbereitung eines mechatronischen Systems eines Nutzfahrzeugs sowie ein mechatronisches System eines Nutzfahrzeugs bereitzustellen, das eine einfache und kostengünstige Wiederaufbereitung ermöglicht bzw. ein mechatronisches System bereitzustellen, die nach der Aufbereitung zuverlässig und sicher betrieben werden kann.

Diese Aufgabe wird erfindungsgemäß gelöst durch ein Verfahren zur Aufbereitung eines mechatronischen Systems für ein Nutzfahrzeug mit den Merkmalen des Anspruchs 1. Danach ist vorgesehen, dass bei einem Verfahren zur Aufbereitung eines mechatronischen Systems für ein Nutzfahrzeug das mechatronische System wenigstens ein Elektronikbauteil und eine wenigstens eine Platine aufweist, wobei das Elektronikbauteil mittels wenigstens eines ersten Konnektorpins auf der Platine befestigt ist und das Verfahren wenigstens die folgenden Schritte aufweist:
- Der erste Konnektorpin wird derart durchtrennt, dass ein Teil des ersten Konnektorpins als Altteilkonnektorpin auf der Platine verbleibt und das Elektronikbauteil von der Platine entfernt werden kann;
- das Elektronikbauteil wird entfernt;
- ein Ersatzelektronikbauteil wird mit einem Ersatzkonnektorpin aufgesetzt; und
- der Altteilkonnektorpin und der Ersatzkonnektorpin werden mit einer Umhüllung umgeben und in der Umhüllung verlötet.

Die Erfindung basiert auf dem Grundgedanken, dass der bestehende Anschluss des Elektronikbauteils mit der Platine, nämlich der Konnektorpin zumindest teilweise wiederverwendet wird. Zu diesem Zweck wird das auszutauschende Elektronikbauteil von der Platine abgelöst und zwar dadurch, dass der wenigstens eine erste Konnektorpin derart durchtrennt wird, dass wenigstens ein Teil des Konnektorpins als Altteilkonnektorpin auf der Platine verbleibt und somit weiterhin als Anschluss bei der Nachrüstung des Ersatzelektronikbauteils als Anschluss zur Verfügung steht. Um sodann eine sichere Verbindung des ausgetauschten Elektronikbauteils, also des Ersatzelektronikbauteils mit der Platine zu erreichen, wird ein Ersatzelektronikbauteil als Austauschteil gewählt, das selbst einen Konnektorpin, nämlich einen Ersatzkonnektorpin, aufweist und mit dem stehengebliebenen Konnektorpinteil (also dem Altteilkonnektorpin), das weiterhin auf der Platine vorhanden ist, verbunden wird. Um eine sichere mechanische und auch elektrische Verbindung zu gewährleisten, wird eine Umhüllung um die beiden Konnektorpins, also um den Altteilkonnektorpin und den Ersatzkonnektorpin gelegt, in der die Verlötung des Altteilkonnektorpins mit dem Ersatzkonnektorpin erfolgt.

Des Weiteren kann vorgesehen sein, dass der erste Konnektorpin mittig durchtrennt wird. Hierdurch wird erreicht, dass der verbleibende Altkonnektorpin auf der Platine eine ausreichende Länge aufweist, um eine mechanisch und elektrisch stabile Verbindung mit dem Konnektorpin des Austauschmagnetventils zu gewährleisten.

Darüber hinaus ist möglich, dass der Ersatzkonnektorpin kürzer ist als der erste Konnektorpin. Insbesondere ist nicht notwendig, dass der Ersatzkonnektorpin, also der Konnektorpin des Ersatzelektronikbauteils eine Länge aufweisen muss, die der Länge des ursprünglichen Konnektorpins entspricht. Darüber hinaus ermöglicht eine derartige Längenwahl des Ersatzkonnektorpins auch ein einfaches Einhalten der zur Verfügung stehenden Abmessungen bzw. eine entsprechende Ausnutzung des zur Verfügung stehenden Raumes innerhalb es Gehäuses des mechatronischen Systems. Etwaige Längenunterschiede können darüber hinaus durch die Lötverbindung und entsprechende Anordnung von erstem Konnektorpin, Ersatzkonnektorpin und der Umhüllung ausgeglichen werden.

Die Umhüllung kann rohrförmig ausgestaltet sein. Dies ermöglicht eine einfache Herstellung der Umhüllung und darüber hinaus eine gleichmäßige Verteilung des Lötmittels in der Umhüllung. Ferner kann durch eine derartige Formgebung der Umhüllung eine gute Stabilität gewährleistet werden.

Insbesondere ist denkbar, dass die im Wesentlichen rohrförmige Umhüllung im Wesentlichen einen kreisrunden Querschnitt aufweist.

Des Weiteren kann vorgesehen sein, dass der Durchmesser der Umhüllung größer ist als der Durchmesser des ersten Konnektorpins und größer als der Durchmesser des Ersatzkonnektorpins ist. Dadurch wird es möglich, dass der erste Konnektorpin und der Ersatzkonnektorpin einfach in die Umhüllung eingeführt werden können.

Ferner ist denkbar, dass der Durchmesser der Umhüllung ca. doppelt so groß ist oder größer als der Durchmesser des Altteilkonnektorpins und/oder des Ersatzkonnektorpins. Dadurch wird es möglich, dass die beiden Konnektorpins auch sich zumindest teilweise in der Umhüllung überlappen können, wodurch eine mechanisch und elektrisch stabile Lötverbindung einfach gewährleistet werden kann.

Das mechatronische System kann eine Luftaufbereitungsanlage eines pneumatischen System seines Nutzfahrzeugs, z.B. die Luftaufbereitungsanlage der pneumatischen Bremsanlage eines Nutzfahrzeugs sein.

Das Elektronikbauteil kann insbesondere ein Magnetventil eines pneumatischen Systems eines Nutzfahrzeugs sein.

Des Weiteren betrifft die vorliegende Erfindung ein mechatronisches System für ein Nutzfahrzeug, insbesondere eines pneumatischen Systems eines Nutzfahrzeugs, aufbereitet gemäß einem Verfahren nach einem wie vorstehend beschrieben.

Darüber hinaus betrifft die vorliegende Erfindung ein mechatronisches System für ein Nutzfahrzeug, insbesondere eines pneumatischen Systems eines Nutzfahrzeugs, wobei das mechatronische System wenigstens ein Elektronikbauteil und wenigstens eine Platine aufweist, wobei das Elektronikbauteil mittels wenigstens eines Altteilkonnektorpins auf der Platine befestigt ist, wobei das Elektronikbauteil einen Ersatzkonnektorpin aufweist und wobei der Altteilkonnektorpin und der Ersatzkonnektorpin von einer Umhüllung umgeben sind, in der der Altteilkonnektorpin und der Ersatzkonnektorpin verlötet sind.

Das mechatronische System kann sämtliche strukturellen und funktionalen Merkmale aufweisen, wie sie vorstehend im Zusammenhang mit dem Verfahren zur Aufbereitung eines mechatronischen Systems beschrieben sind. Bei dem mechatronischen System kann es sich insbesondere um ein wiederaufbereitete mechatronisches System handeln, das insbesondere gemäß einem vorstehend beschriebenen Verfahren zur Aufbereitung einer Luftaufbereitungsanlage wiederaufbereitet wurde.

Die Umhüllung kann im Wesentlichen rohrförmig ausgebildet sein. Insbesondere ist denkbar, dass die im Wesentlichen rohrförmige Umhüllung im Wesentlichen einen kreisrunden Querschnitt aufweist.

Grundsätzlich ist es aber auch denkbar, dass die Umhüllung teilweise rohrförmig oder eine andere geeignete Ausführung oder Gestaltung aufweist. Insbesondere kann die Umhüllung kreisförmig oder rohrförmig sein. Des Weiteren ist denkbar, dass die Umhüllung ein Hohlrohr ist, insbesondere ein kreisförmiges Hohlrohr.

Ferner kann vorgesehen sein, dass der Durchmesser der Umhüllung größer ist als der Durchmesser des Altteilkonnektorpins und größer als der Durchmesser des Ersatzteilkonnektorpins.

Weiter kann vorgesehen sein, dass der Durchmesser der Umhüllung ca. doppelt so groß oder größer als der Durchmesser des Altteilkonnektorpins und des Ersatzteilkonnektorpins ist.

Sämtliche im Zusammenhang mit der Luftaufbereitungsanlage vorstehend beschriebenen strukturellen und funktionalen Merkmale können einzeln oder in Kombinatin auch bei dem Verfahren zur Aufbereitung einer Luftaufbereitungsanlage vorgesehen sein.

Das mechatronische System kann eine Luftaufbereitungsanlage eines pneumatischen System seines Nutzfahrzeugs, z.B. die Luftaufbereitungsanlage der pneumatischen Bremsanlage eines Nutzfahrzeugs sein.

Das Elektronikbauteil kann insbesondere ein Magnetventil eines pneumatischen Systems eines Nutzfahrzeugs sein.

Bei der Platine kann es sich insbesondere um die sog. ECU (Electronic Control Unit - Steuerplatine der Luftaufbereitungsanlage) handeln.

Das vorstehende Verfahren bzw. das vorstehend beschriebene mechatronische System ermöglichen es insbesondere, z.B. bei pneumatischen System für Nutzfahrzeuge, hier insbesondere pneumatische Bremsanlagen, die alten Magnetventile der Luftaufbereitsungsanlage schonend und ohne Eingriff in die Platine bzw. die ECU auszutauschen, nämlich dadurch, dass diese einfach abgeschnitten werden. Die neuen Magnetventile können somit auf die ECU aufgesetzt werden und die vorhandene Befetigung durch den verbleibenden Teil des Konnektorpins kann genutzt werden. Weiter werden die Konnektorpins derart gekürzt, dass keine Beschädigung der ECU entsteht. Die Verbindungspins der neuen Magnetventile und der alten Stempel an der ECU werden umhüllt und in der Hülle verlötet. Hierdurch wird es möglich, einen Hitzeeintrag in die ECU zu vermeiden. Darüber hinaus wird die Menge an appliziertem Lötzinn durch die Umhüllung kontrolliert, was zu einer Prozesssicherheit führt und einen konstanten Lötzinnverbrauch gewährleistet.

Weitere Einzelheiten und Vorteile sollen nun anhand der eines in der Zeichnung dargestellten Ausführungsbeispiels näher erläutert werden:
- Fig. 1: Zeigt eine Draufsicht auf ein Gehäuse eines Ausführungsbeispiels eines erfindungsgemäßen mechatronischen Systems, hier eine Luftaufbereitungsanlage, die gemäß dem erfindungsgemäßen Verfahren zur Aufbereitung eines mechatronischen aufbereitet wurde;
- Fig. 2: Zeigt eine Draufsicht auf eine geöffnete Luftaufbereitungsanlage;
- Fig. 3: Zeigt eine Draufsicht auf die geöffnete Luftaufbereitungsanlage gemäß Figur 1 mit einer weiteren Detaildarstellung;
- Fig. 4: Zeigt eine Detaildarstellung in perspektivischer Ansicht auf die Luftaufbereitungsanlage;
- Fig. 5: Zeigt eine weitere Detaildarstellung in perspektivischer Ansicht;
- Fig. 6: Zeigt eine weitere Detaildarstellung;
- Fig. 7: Zeigt eine perspektivische Ansicht auf ein Heizelement in einem ersten, wiederverwendbaren Zustand;
- Fig. 8: Zeigt eine perspektivische Ansicht auf ein Heizelement in einem zweiten, nicht wiederverwendbaren Zustand;
- Fig. 9: Zeigt eine perspektivische Ansicht auf ein Heizelement in einem zweiten, nicht wiederverwendbaren Zustand;
- Fig. 10: Zeigt in perspektivischer Darstellung den Entfernungsvorgang eines Magnetventils von der Platine;
- Fig. 11: Zeigt in perspektivischer Darstellung das Aufsetzen und Verlöten eines Ersatzmagnetventils auf die Platine;
- Fig. 12: Zeigt in perspektivischer Darstellung den Fortgang des Verlötens des Ersatzmagnetventils auf die Platine;
- Fig. 13: Zeigt eine weitere Detaildarstellung auf ein Magnetventil sowie die Verbindung mit der Platine;
- Fig. 14: Zeigt eine weitere Detaildarstellung in perspektivischer Ansicht auf die Verbindung des Magnetventils mit der Platine;
- Fig. 15: Zeigt eine schematische Darstellung der Verbindung des Magnetventils mit dem ersten und zweiten Konnektorpin sowie der Umhüllung und der Verlötung;
- Fig. 16: Zeigt in perspektivischer Darstellung den (Wieder-)Einbau eines Heizelements;
- Fig. 17: Zeigt beispielhaft den Zusammenbau der aufbereiteten Luftaufbereitungsanlage;
- Fig. 18: Zeigt eine Detailansicht auf die Lötverbindungen des Anschlusskonnektors auf der Platine; und
- Fig. 19: Zeigt schematisch Qualitätskriterien für die Lötverbindung des Anschlusskonnektors auf der Platine.

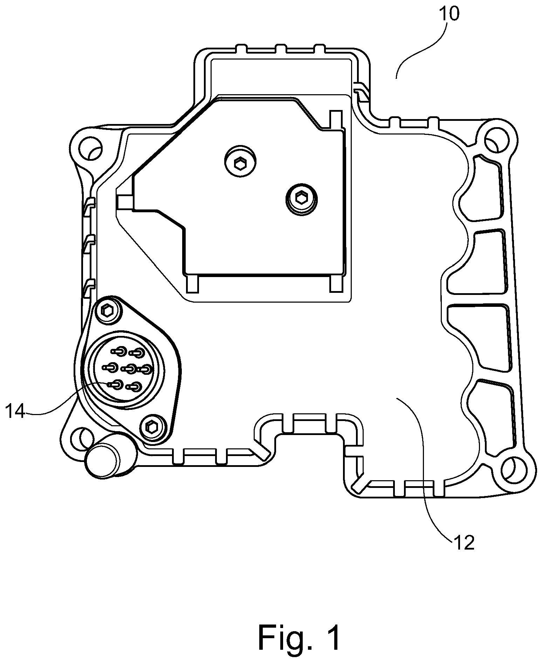

**Fig. 1** zeigt in der Draufsicht ein Ausführungsbeispiel eines erfindungsgemäßen mechatronischen Systems 10, hier eine Luftaufbereitungsanlage 10, das gemäß dem erfindungsgemäßen Verfahren aufbereitet wurde.

Die Luftaufbereitungsanlage 10 weist dabei ein Gehäuse 12 auf, aus dem ein Anschlusskonnektor 14 heraussteht.

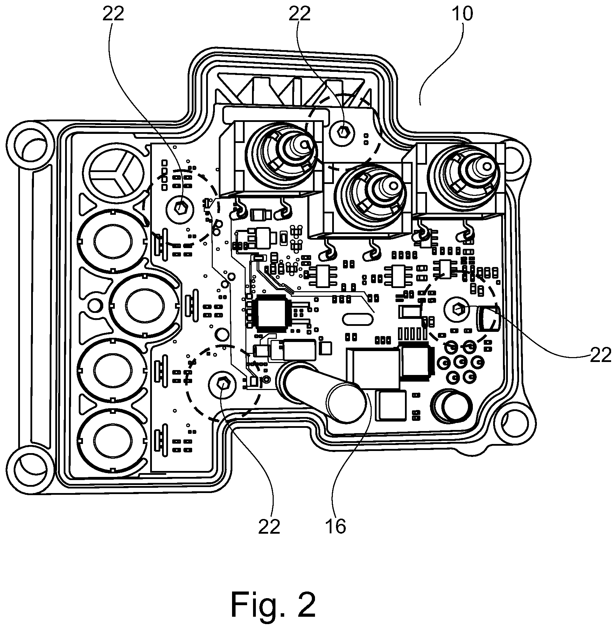

**Fig. 2** zeigt die Luftaufbereitungsanlage 10 gemäß Fig. 1 in geöffnetem Zustand und mit Blick auf die Platine 16, auch ECU 16, genannt.

Auf der Platine 16 sind mehrere Ektronikbauteile 18, hier Magnetventile 18 angeordnet.

Jedes Magnetventil 18 weist mehrere Verbindungsstellen 20 mit der Platine 16 auf.

Wie in Fig. 1 gezeigt, wird in einem ersten Schritt das Gehäuse 12 in einer Wiederaufbereitungsaufnahme, die nicht näher gezeigt ist, befestigt. Sodann werden die Schrauben 22 des Konnektors 30 entfernt. Diese Schrauben 22 können entsorgt werden. Die Entfernung der Schrauben 22 kann beispielsweise mit einem druckluftbetriebenen Schraubenzieher erfolgen.

In einem zweiten Schritt wird sodann der Gehäusedeckel entfernt und die Rückseite des Gehäuses 12 offengelegt. Sodann werden die vier Schrauben 22, mittels derer die ECU 16 im Gehäuse 12 befestigt ist, entfernt, vorzugsweise ebenfalls mit dem druckluftbetriebenen Schraubenzieher. Diese Schrauben 22 werden für die Wiederverwendung aufgehoben.

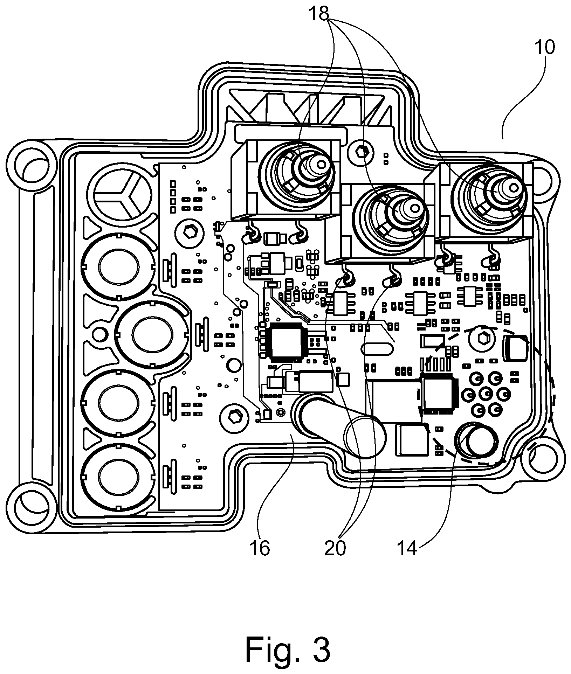

**Fig. 3** zeigt den nächsten Schritt des Verfahrens zur Aufbereitung.

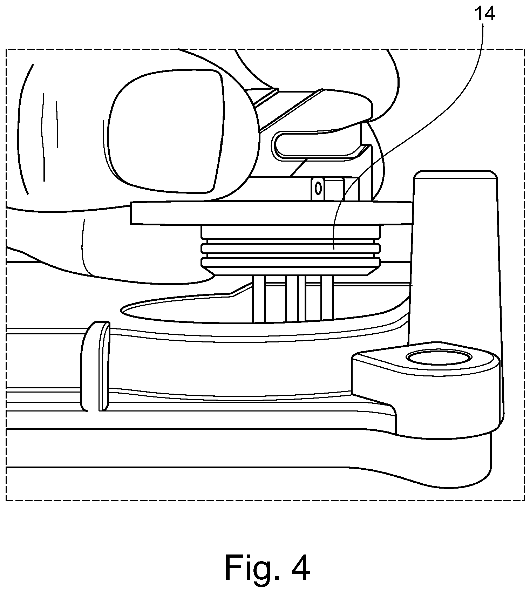

In einem nächsten Schritt werden die sieben Konnektorpins des Anschlusskonnektors 14 des Luftaufbereitungsgehäuses entlötet, um diesen, wie in **Fig. 4** gezeigt, ohne Kraftaufwand zu entfernen. Zur Entlötung wird eine Vakuum-Entlötungsvorrichtung verwendet. Die Lötspitze kann ca. 1,5 mm betragen und die verwendete Temperatur zum Enlötvorgang ca. 385 °C.

Wie in der Ecke von Fig. 4 gezeigt, soll hier ein Verkippen vermieden werden und der Konnektor 14 gerade bzw. senkrecht aus der Platine 16 herausgezogen werden. In diesem Zusammenhang wird auch überprüft, ob der Konnektor beschädigt wird. Üblicherweise kann der Konnektor wiederverwendet werden, was jedoch durch eine entsprechende Sicht und ggf. elektrische Überprüfung verifiziert wird.

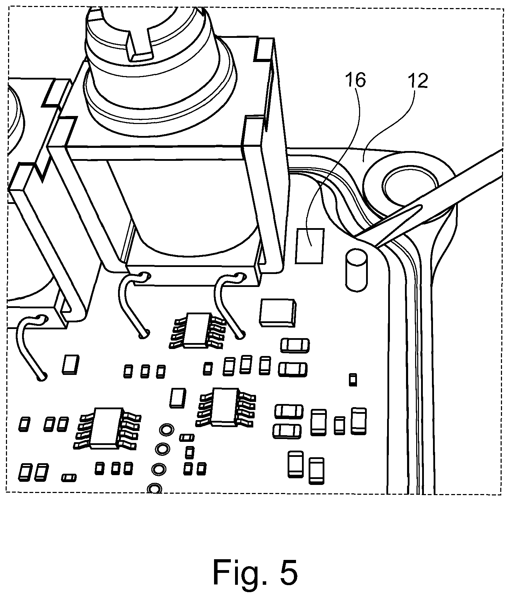

Wie in **Fig. 5** gezeigt, wird sodann die ECU 16 aus dem Gehäuse 12 entfernt, was beispielsweise durch leichtes Anlupfen mittels eines Schraubenziehers entfernt werden kann. Hierzu ist nur ein geringer Kraftaufwand notwendig.

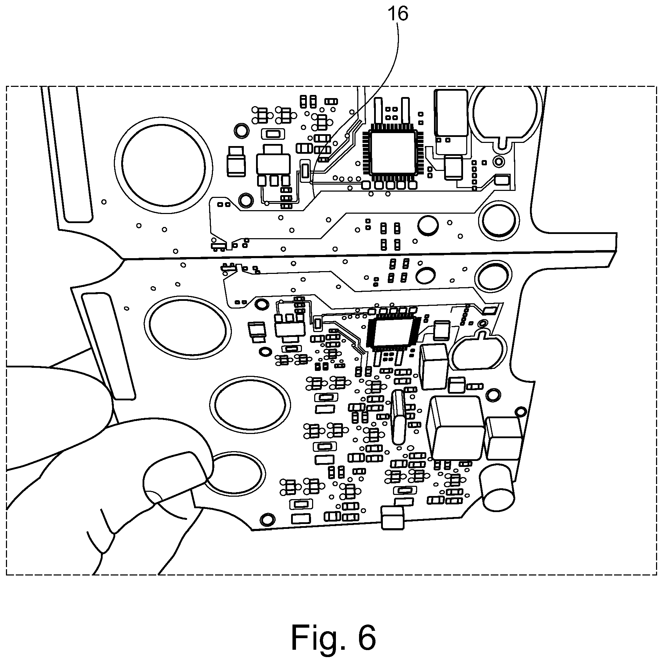

In **Fig. 6** ist zu sehen, dass die Platine 16 gereinigt wird, wobei insbesondere die Drucksensoren gereinigt werden. Hierzu kann ein entsprechendes Reinigungsmittel wie beispielsweise electrolube safewash ® benutzt werden und eine Spülung mit deionisiertem Wasser vorgenommen werden. Das verwendete Reinigungsmittel kann eine Temperatur von ca. 50-60 °C aufweisen.

Zur Trocknung kann die Platine in einen Trocknungsofen von ca. 60° für eine Zeitraum von ca. 30 Minuten eingebracht werden.

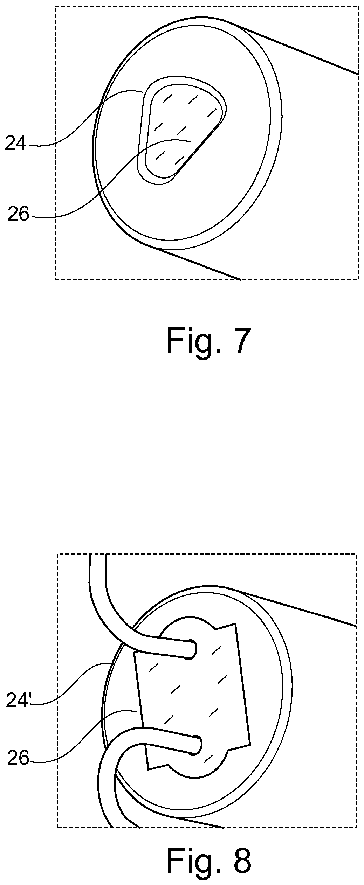

**Fig. 7** zeigt eine perspektivische Ansicht auf ein Heizelement 24 der Luftaufbereitungsanlage 10 in einem ersten, wiederverwendbaren Zustand.

**Fig. 8** zeigt eine perspektivische Ansicht auf ein Heizelement 24' der Luftaufbereitungsanlage 10 in einem zweiten, nicht wiederverwendbaren Zustand.

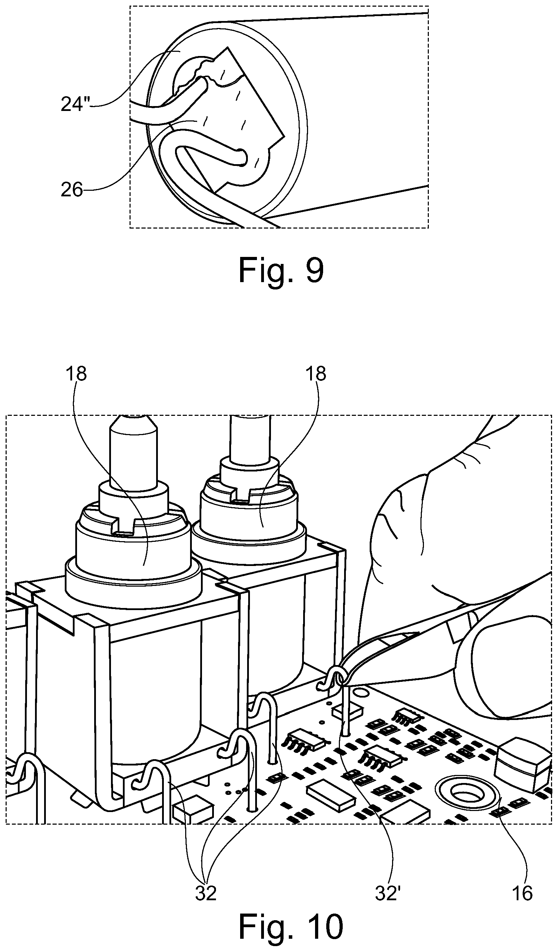

**Fig. 9** zeigt eine perspektivische Ansicht auf ein Heizelement 24" der Luftaufbereitungsanlage 10 in einem zweiten, nicht wiederverwendbaren Zustand.

Wenn, wie in Fig. 7 gezeigt, dass Füllmaterial 26 nur zusammengedrückt bzw. geschrumpft ist, dann kann das Heizelement 24 wiederverwendet werden. Der Widerstand des Heizelements 24 wird dann geprüft und sollte bei ca. 8-10 Ohm liegen.

Wenn aber, wie in den Fig. 8 und 9 gezeigt, das Heizelement 24' bzw. 24" Beschädigungen aufweist, z.B. jeweils einen Sprung im Füllmaterial 26, dann wird das Heizelement entfernt und ausgetauscht. Hierzu werden die Lötverbindungen entlötet, z.B. unter Verwendung einer Vakuum-Entlötungsvorrichtung. Die Lötspitze kann ca. 1,0 mm betragen und die verwendete Temperatur zum Enlötvorgang ca. 385 °C.

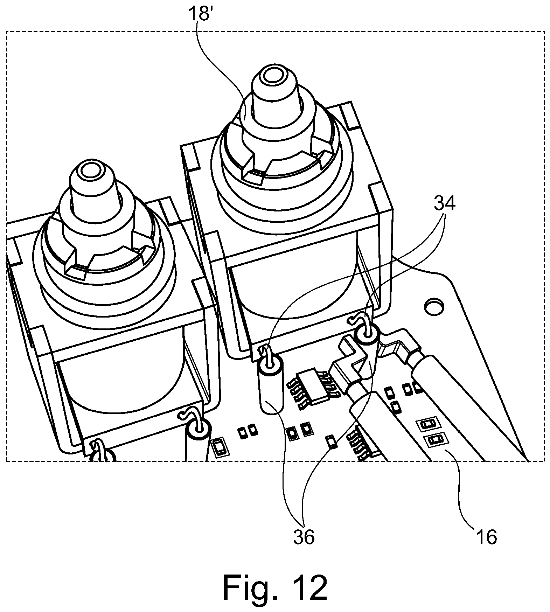

Um nun die dem Verschleiß unterliegenden (Original-)Magnetventile 18 auszutauschen, wird wie in den **Figuren 10 bis 15** gezeigt vorgegangen.

Das Magnetventil 18 (z.B. das Orginalmagnetventil 18) ist mittels zweier Originalkonnektorpins 32 (auch erste Konnektorpins 32 genannt) mit der Platine 16 verbunden.

Zunächst werden die bestehenden Konnektorpins 32 des Magnetventils 18 bzw. die bestehenden Konnektorpins 32 des Magnetventils 18 derart getrennt, dass erste Teile der Konnektorpins 32 als Altteilkonnektorpins 32' auf der ECU 16 verbleiben und das alte, dem Verschleiß unterliegende Magnetventil 18 von der ECU 16 entfernt werden kann.

Vorzugsweise wird hierzu der erste Konnektorpin 32 mittig durchtrennt. Im in Fig. 10 gezeigten Ausführungsbeispiel wird der Konnektorpin 32 derart abgeschnitten, dass der Altteilkonnektorpin 32' aus der ECU 16 ca. 9-9,5 mm aus der Platine 16 heraussteht. Man kann hierzu direkt unterhalb des gebogenen Teils des Konnektorpins 32 abzwicken.

Nach der Entfernung des alten Magnetventils 18 wird ein neues Ersatzmagnetventil 18' als Ersatzelektronikbauteil 18' mit einem Ersatzkonnektorpin 34 aufgesetzt, wobei dieser Ersatzkonnektorpin 34 eine geringere Länge aufweist, als dies bei dem ersten Konnektorpin 32, dem Originalkonnektorpin 32, der Fall war.

Insbesondere kann weiter auch vorgesehen sein, dass der Ersatzkonnektorpin 34 kürzer ist als der erste Konnektorpin 32.

Der Altteilkonnektorpin 32' und der Ersatzkonnektorpin 34 werden mit einer Umhüllung 36 umgeben und in der Umhüllung 36 verlötet.

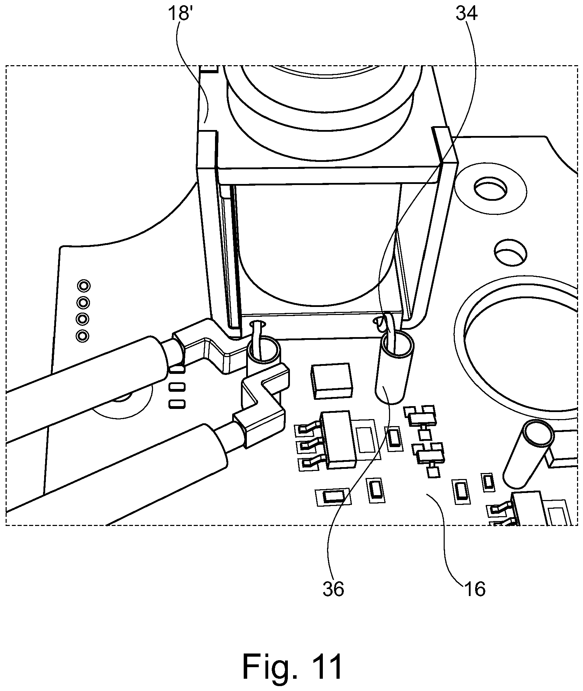

Wie weiter in den Fig. 11 bis 15 ersichtlich, ist die Umhüllung 36 selbst kreisförmig rohrförmig ausgebildet. Der Durchmesser der Umhüllung 36 ist größer als der Durchmesser des ersten Konnektorpins 32 und größer als der Durchmesser des zweiten Konnektorpins 34, also des Ersatzkonnektorpins 34, und zwar ca. doppelt so groß wie der Durchmesser des Altteilkonnektorpins 32' und des Ersatzkonnektorpins 34. Grundsätzlich kann auch vorgesehen sein, dass die Umhüllung 36 noch größer ausgeführt ist.

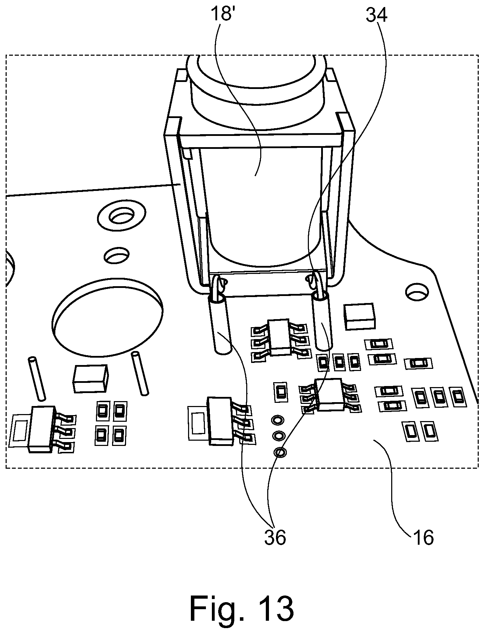

**Fig. 13** zeigt eine weitere Detaildarstellung auf das Ersatzmagnetventil 18' sowie die Verbindung mit der Platine 16.

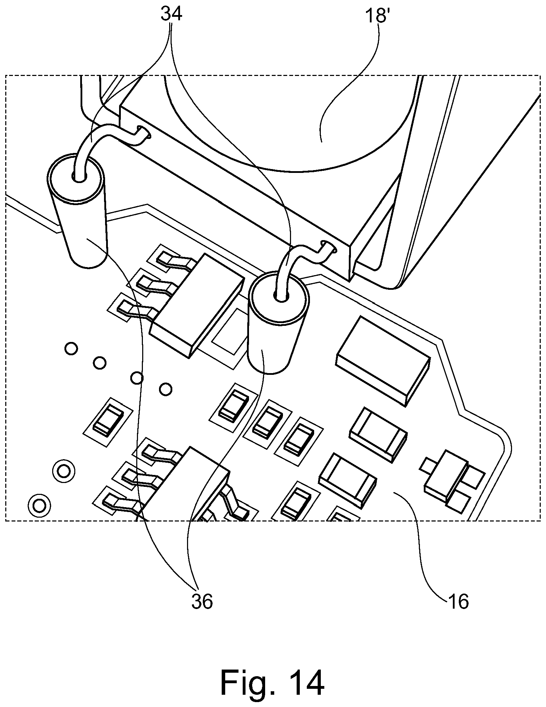

**Fig. 14** zeigt eine weitere Detaildarstellung in perspektivischer Ansicht auf die Verbindung des Ersatzmagnetventil 18' mit der Platine 16.

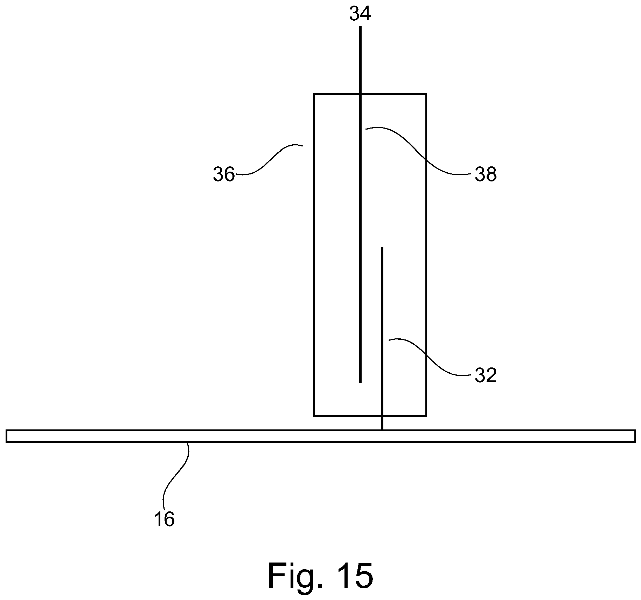

**Fig. 15** zeigt eine schematische Darstellung der Verbindung der Platine 16 und des Ersatzmagnetventils 18' mit dem Altteilkonnektorpin 32' und dem Ersatzkonnektorpin 34 sowie der Umhüllung und der Lötverbindung 38.

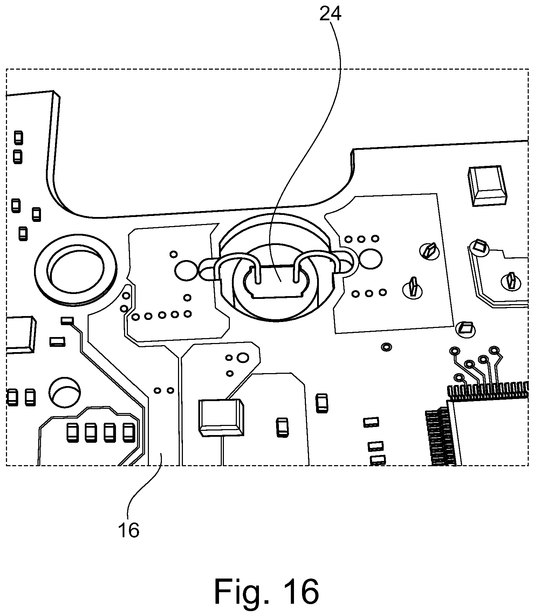

**Fig. 16** zeigt in perspektivischer Darstellung den (Wieder-)Einbau eines Heizelements 24 (vgl. Fig. 7) auf der Platine 16. Die Konnektoren werden in den Aufnahmen in der Platine auch derart platziert, dass hierdurch die Länge bzw. das Herausstehen des Heizelements 24 aus der Platine 16 eingestellt wird. Die Konnektoren werden mit einer 63/37-Zinn/Blei-Mischung verlötet.

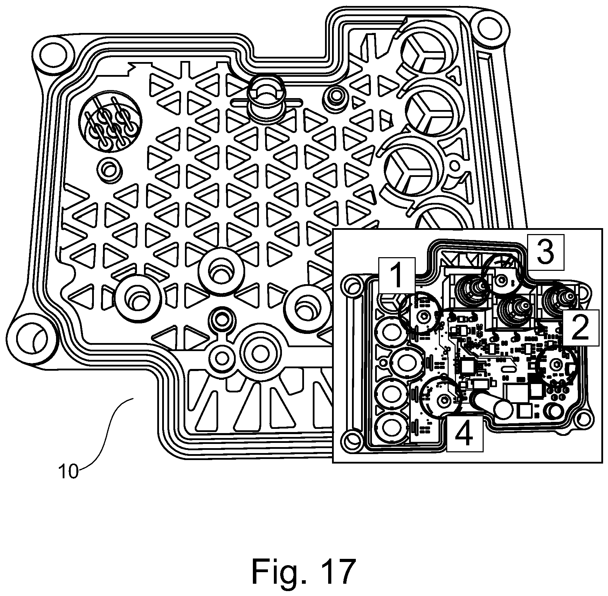

**Fig. 17** zeigt beispielhaft den Zusammenbau der aufbereiteten Luftaufbereitungsanlage. Die beiden Gehäusehälften der Luftaufbereitungsanlage 10 werden zusammengesetzt, wobei auf das Heizelement und die Drucksensoren besonders geachtet werden muss.

Die Schrauben 22 (siehe Fig. 2) werden in der Reihenfolge 1-2-3-4 unter Verwendung eines druckluftbetriebenen Schraubendrehers eingeschraubt. Das Drehmoment beträgt 2.7 (+0.3) Nm.

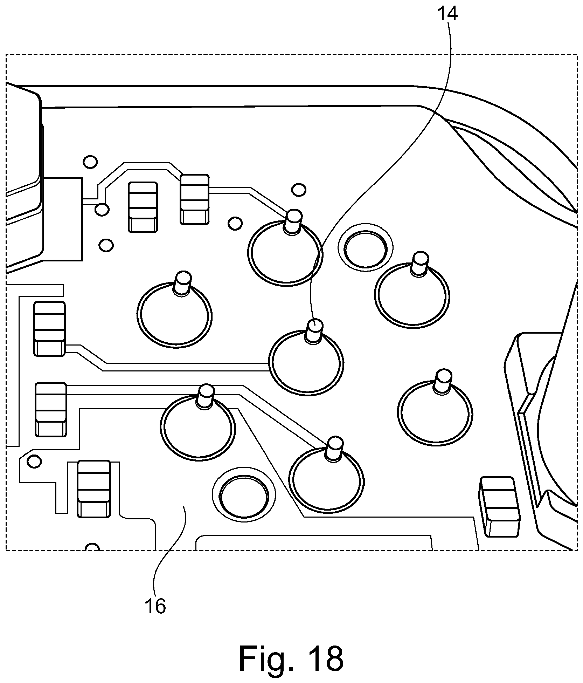

**Fig. 18** zeigt eine Detailansicht auf die Lötverbindungen des Anschlusskonnektors 14 auf der Platine 16.

Die Konnektoren des Anschlusskonnektors 14 werden mit einer 63/37-Zinn/Blei-Mischung mit der Platine 16 verlötet und zwar bei ca. 385 °C Es wird kein Flussmittel verwendet bzw. wird dieses entfernt.

Vorzugsweise wird ein Lötkolben mit einer meißelartigen Spitze verwendet, z.B. eine 3mm Spitze.

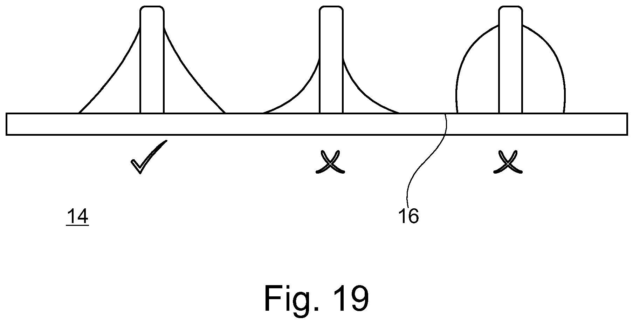

**Fig. 19** zeigt schematisch Qualitätskriterien für die Lötverbindung des Anschlusskonnektors 14 auf der Platine 16, links korrekt, mitte und rechts nicht korrekt. Jede Lötverbindung für einen Pin wird ca. 2-3 Sekunden verlötet.

### BEZUGSZEICHENLISTE

- 10: mechatronisches System; Luftaufbereitungsanlage
- 12: Gehäuse
- 14: Anschlusskonnektor
- 16: Platine
- 18: Magnetventil
- 18': Ersatzelektronikbauteil; Ersatzmagnetventil
- 20: Verbindungsstelle
- 22: Schraube
- 24: Heizelement
- 24': Heizelement
- 24": Heizelement
- 26: Füllmaterial
- 30: Konnektor
- 32: Originalkonnektorpin; erster Konnektorpin
- 32': Altteilkonnektorpin
- 34: Ersatzkonnektorpin
- 36: Umhüllung
- 38: Lötverbindung

## Patentansprüche

1. Verfahren zur Aufbereitung eines mechatronischen Systems (10) für ein Nutzfahrzeug wobei das mechatronische System (10) wenigstens ein Elektronikbauteil (18) und wenigstens eine Platine (16) aufweist, wobei das Elektronikbauteil (18) mittels wenigstens eines ersten Konnektorpins (32) auf der Platine (16) befestigt ist, mit wenigstens den folgenden Schritten:
- Der erste Konnektorpin (32) wird derart durchtrennt, dass ein Teil des ersten Konnektorpins (32) als Altteilkonnektorpin (32') auf der Platine (16) verbleibt und das Elektronikbauteil (18) von der Platine (16) entfernt werden kann;
- das Elektronikbauteil (18) wird entfernt;
- ein Ersatzelektronikbauteil (18') wird mit einem Ersatzkonnektorpin (34) aufgesetzt;
- der Altteilkonnektorpin (32') und der Ersatzkonnektorpin (34) werden mit einer Umhüllung (36) umgeben und in der Umhüllung (36) verlötet.

2. Verfahren nach Anspruch 1,
**dadurch gekennzeichnet, dass**
der erste Konnektorpin (32) im Wesentlichen mittig durchtrennt wird.

3. Verfahren nach Anspruch 1 oder Anspruch 2,
**dadurch gekennzeichnet, dass**
der Ersatzkonnektorpin (34) kürzer ist als der erste Konnektorpin (32).

4. Verfahren nach einem der vorhergehenden Ansprüche,
**dadurch gekennzeichnet, dass**
die Umhüllung (36) im Wesentlichen rohrförmig ist.

5. Verfahren nach Anspruch 4,
**dadurch gekennzeichnet, dass**
der Durchmesser der Umhüllung (36) größer als der Durchmesser des ersten Konnektorpins (32) und größer als der Durchmesser des Ersatzkonnektorpins (34) ist.

6. Verfahren nach Anspruch 5,
**dadurch gekennzeichnet, dass**
der Durchmesser der Umhüllung (36) doppelt so groß oder größer als der Durchmesser des Altteilkonnektorpins (32') und/oder des Ersatzkonnektorpins (34) ist.

7. Verfahren nach einem der vorhergehenden Ansprüche,
**dadurch gekennzeichnet, dass**
das mechatronische System (10) eine Luftaufbereitungsanlage eines pneumatischen Systems eines Nutzfahrzeugs ist.

8. Verfahren nach einem der vorhergehenden Ansprüche,
**dadurch gekennzeichnet, dass**
das Elektronikbauteil (18) ein Magnetventil eines pneumatischen Systems eines Nutzfahrzeugs ist.

9. Mechatronisches System (10) für ein Nutzfahrzeug, wobei das mechatronische System (10) wenigstens ein Elektronikbauteil (18) und wenigstens eine Platine (16) aufweist,
**dadurch gekennzeichnet, dass**
das Elektronikbauteil (18) mittels wenigstens eines Ersatzkonnektorpins (34), mittels eines Altteilkonnektorpins (32') und mittels einer Umhüllung (36) auf der Platine (16) befestigt ist, wobei der Ersatzkonnektorpin (34) und der Altteilkonnektorpin (32') von der Umhüllung (36) umgeben sind und wobei Ersatzkonnektorpin (34) und der Altteilkonnektorpin (32') in der Umhüllung (36) verlötet sind.

10. Mechatronisches System (10) nach Anspruch 9,
**dadurch gekennzeichnet, dass**
die Umhüllung (36) im Wesentlichen rohrförmig ist.

11. Mechatronisches System (10) nach Anspruch 9 oder nach Anspruch 10,
**dadurch gekennzeichnet, dass**
der Durchmesser der Umhüllung (36) größer als der Durchmesser des Altteilkonnektorpins (32') und größer als der Durchmesser des Ersatzkonnektorpins (34) ist.

12. Mechatronisches System (10) nach einem der Ansprüche 9 bis 11,
**dadurch gekennzeichnet, dass**
der Durchmesser der Umhüllung doppelt so groß oder größer als der Durchmesser des Altteilkonnektorpins (32') und/oder des Ersatzkonnektorpins (34) ist.

13. Mechatronisches System (10) nach einem der Ansprüche 10 bis 12,
**dadurch gekennzeichnet, dass**
das mechatronische System (10) eine Luftaufbereitungsanlage eines pneumatischen Systems eines Nutzfahrzeugs ist.

14. Mechatronisches System (10) nach einem der Ansprüche 10 bis 13,
**dadurch gekennzeichnet, dass**
das Elektronikbauteil (18) ein Magnetventil eines pneumatischen Systems eines Nutzfahrzeugs ist.

## Claims

1. Method for preparing a mechatronic system (10) for a commercial vehicle, wherein the mechatronic system (10) comprises at least one electronic component (18) and at least one printed circuit board (16), wherein the electronic component (18) is secured to the printed circuit board (16) by means of at least one first connector pin (32), the method comprising at least the following steps:
- the first connector pin (32) is severed in such a way that a part of the first connector pin (32) remains on the printed circuit board (16) as a used part connector pin (32') and the electronic component (18) can be removed from the printed circuit board (16);
- the electronic component (18) is removed;
- a replacement electronic component (18') is fitted with a replacement connector pin (34);
- the used part connector pin (32') and the replacement connector pin (34) are enclosed in a sheath (36) and soldered in the sheath (36).

2. Method according to claim 1,
**characterised in that**
the first connector pin (32) is severed substantially in the centre.

3. Method according to claim 1 or 2,
**characterised in that**
the replacement connector pin (34) is shorter than the first connector pin (32).

4. Method according to any of the preceding claims,
**characterised in that**
the sheath (36) is substantially tubular.

5. Method according to claim 4,
**characterised in that**
the diameter of the sheath (36) is larger than the diameter of the first connector pin (32) and larger than the diameter of the replacement connector pin (34).

6. Method according to claim 5,
**characterised in that**
the diameter of the sheath (36) is twice as large as or larger than the diameter of the used part connector pin (32') and/or the replacement connector pin (34).

7. Method according to any of the preceding claims,
**characterised in that**
the mechatronic system (10) is an air treatment system of a pneumatic system of a commercial vehicle.

8. Method according to any of the preceding claims,
**characterised in that**
the electronic component (18) is a solenoid valve of a pneumatic system of a commercial vehicle.

9. Mechatronic system (10) for a commercial vehicle, wherein the mechatronic system (10) comprises at least one electronic component (18) and at least one printed circuit board (16),
**characterised in that**
the electronic component (18) is secured to the printed circuit board (16) by means of a replacement connector pin (34), a used part connector pin (32') and a sheath (36), wherein the replacement connector pin (34) and the used part connector pin (32') are enclosed by the sheath (36) and wherein the replacement connector pin (34) and the used part connector pin (32') are soldered in the sheath (36).

10. Mechatronic system (10) according to claim 9,
**characterised in that**
the sheath (36) is substantially tubular.

11. Mechatronic system (10) according to claim 9 or claim 10,
**characterised in that**
the diameter of the sheath (36) is larger than the diameter of the used part connector pin (32') and larger than the replacement connector pin (34).

12. Mechatronic system (10) according to any of claims 9 to 11,
**characterised in that**
the diameter of the sheath (36) is twice as large as or larger than the diameter of the used part connector pin (32') and/or the replacement connector pin (34).

13. Mechatronic system (10) according to any of claims 10 to 12,
**characterised in that**
the mechatronic system (10) is an air treatment system of a pneumatic system of a commercial vehicle.

14. Mechatronic system (10) according to any of claims 10 to 13,
**characterised in that**
the electronic component (18) is a solenoid valve of a pneumatic system of a commercial vehicle.

## Revendications

1. Procédé de préparation d'un système (10) mécatronique d'un véhicule utilitaire, le système (10) mécatronique ayant au moins un composant (18) électronique et au moins une platine (16), le composant (18) électronique étant fixé sur la platine (16) au moyen d'au moins une première broche (32) de connecteur, comprenant au moins les stades suivants :
- on sépare la première broche (32) de connecteur, de manière à laisser une partie de la première broche (32) de connecteur sur la platine (16), comme vieille broche (32') de connecteur, et à pouvoir retirer le composant (18) électronique de la platine 16 ;
- on retire le composant (18) électronique ;
- on met un composant (18') électronique de remplacement par une broche (34) de connecteur de remplacement ;
- on entoure la vieille broche (32') de connecteur et la broche (34) de connecteur de remplacement d'une enveloppe (36) et on les brase dans l'enveloppe (36).

2. Procédé suivant la revendication 1,
**caractérisé en ce que**
l'on sépare sensiblement au milieu la première broche (32) de connecteur.

3. Procédé suivant la revendication 1 ou la revendication 2,
**caractérisé en ce que**
la broche (34) de connecteur de remplacement est plus courte que la première broche (32) de connecteur.

4. Procédé suivant l'une des revendications précédentes,
**caractérisé en ce que**
l'enveloppe (36) est sensiblement tubulaire.

5. Procédé suivant la revendication 4,
**caractérisé en ce que**
le diamètre de l'enveloppe (36) est plus grand que le diamètre de la première broche (32) de connecteur et plus grand que le diamètre de la broche (34) de connecteur de remplacement.

6. Procédé suivant la revendication 5,
**caractérisé en ce que**
le diamètre de l'enveloppe (36) est deux fois aussi grand ou plus grand que le diamètre de la vieille broche (32') de connecteur et/ou de la broche (34) de connecteur de remplacement.

7. Procédé suivant l'une des revendications précédentes,
**caractérisé en ce que**
le système (10) mécatronique est une installation de traitement de l'air d'un système pneumatique d'un véhicule utilitaire.

8. Procédé suivant l'une des revendications précédentes,
**caractérisé en ce que**
le composant (18) électronique est une électrovanne d'un système pneumatique d'un véhicule utilitaire.

9. Système (10) mécatronique d'un véhicule utilitaire d'un système (10) mécatronique, ayant un composant (18) électronique et au moins une platine (16),
**caractérisé en ce que**
le composant (18) électronique est fixé sur la platine (16) au moyen d'au moins une broche (34) de connecteur de remplacement, au moyen d'une vieille broche (32') de connecteur et au moyen d'une enveloppe (36), la broche (34) de connecteur de remplacement et la vieille broche (32') de connecteur étant entourées de l'enveloppe (36) et la broche (34) de connecteur de remplacement et la vieille broche (32') de connecteur étant brasées dans l'enveloppe (36).

10. Système (10) mécatronique suivant la revendication 9,
**caractérisé en ce que**
l'enveloppe (36) est sensiblement tubulaire.

11. Système (10) mécatronique suivant la revendication 9 ou la revendication 10,
**caractérisé en ce que**
le diamètre de l'enveloppe (36) est plus grand que le diamètre de la première broche (32) de connecteur est plus grand que le diamètre de la broche (34) de connecteur de remplacement.

12. Système (10) mécatronique suivant l'une des revendications 9 à 11,
**caractérisé en ce que**
le diamètre de l'enveloppe (36) est deux fois aussi grand ou plus grand que le diamètre de la vieille broche (32') de connecteur et/ou de la broche (34) de connecteur de remplacement.

13. Système (10) mécatronique suivant l'une des revendications 10 à 12,
**caractérisé en ce que**
le système (10) mécatronique est une installation de traitement de l'air d'un système pneumatique d'un véhicule utilitaire.

14. Système (10) mécatronique suivant l'une des revendications 10 à 13,
**caractérisé en ce que**
le composant (18) électronique est une électrovanne d'un système pneumatique d'un véhicule utilitaire.
